(19) Europäisches Patentamt
European Patent Office
Office européen des brevets

(11) **EP 3 435 546 B1**

(12) **FASCICULE DE BREVET EUROPEEN**

(45) Date de publication et mention
de la délivrance du brevet:
**25.11.2020 Bulletin 2020/48**

(51) Int Cl.:
*H03K 19/185* (2006.01)    *H03K 19/20* (2006.01)
*H03K 19/00* (2006.01)    *H01G 5/16* (2006.01)

(21) Numéro de dépôt: **18184792.2**

(22) Date de dépôt: **20.07.2018**

(54) **CELLULE LOGIQUE CAPACITIVE**

KAPAZITIVE LOGISCHE ZELLE

CAPACITIVE LOGIC CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.07.2017 FR 1757060**

(43) Date de publication de la demande:
**30.01.2019 Bulletin 2019/05**

(73) Titulaire: **Commissariat à l'Energie Atomique et aux Energies
Alternatives
75015 Paris (FR)**

(72) Inventeurs:
- **PILLONNET, Gaël**
  **38120 PROVEYSIEUX (FR)**
- **PERRIN, Yann**
  **38000 GRENOBLE (FR)**
- **GALISULTANOV, Ayrat**
  **38000 GRENOBLE (FR)**
- **FANET, Hervé**
  **38420 REVEL (FR)**

(74) Mandataire: **Cabinet Beaumont
4, Place Robert Schuman
B.P. 1529
38025 Grenoble Cedex 1 (FR)**

(56) Documents cités:
**JP-A- H09 153 436    US-A1- 2017 179 954
US-B1- 6 242 989**

- **HYUN-HO YANG ET AL: "Electrostatic micro-actuator with a pre-charged series capacitor: modeling, design, and demonstration", JOURNAL OF MICROMECHANICS & MICROENGINEERING, INSTITUTE OF PHYSICS PUBLISHING, BRISTOL, GB, vol. 24, no. 6, 6 mai 2014 (2014-05-06), page 65012, XP020264620, ISSN: 0960-1317, DOI: 10.1088/0960-1317/24/6/065012 [extrait le 2014-05-06]**

**Description**

Domaine

La présente demande concerne le domaine des cellules logiques réalisées à base de condensateurs à capacité variable.

Exposé de l'art antérieur

La demande de brevet européen N°16204534 déposée le 15 décembre 2016 et la demande de brevet américain correspondante N°15/381477 déposée le 16 décembre 2016, décrivent des exemples de réalisation de cellules logiques à base de condensateurs à capacité variable à quatre électrodes.

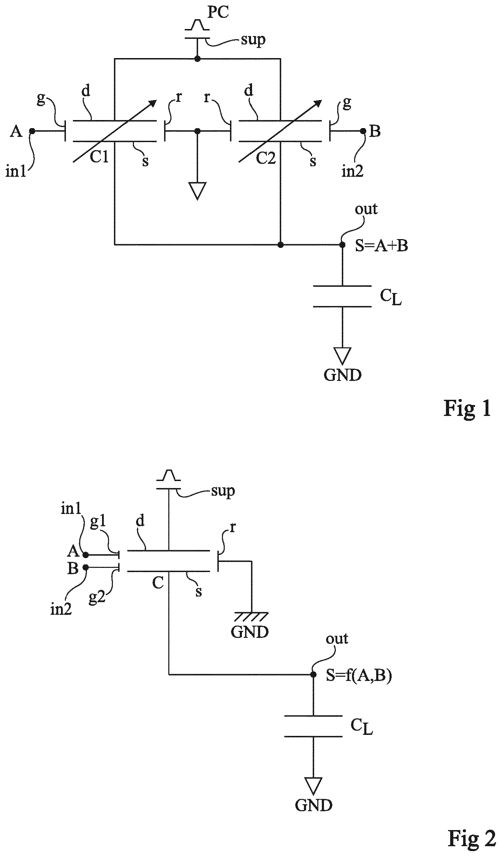

La figure 1 illustre de façon schématique une cellule logique du type décrit dans les demandes de brevet susmentionnées. La cellule de la figure 1 comprend deux condensateurs à capacité variable C1 et C2. Chacun des condensateurs C1 et C2 est un dispositif à quatre électrodes d, s, g et r isolées électriquement les unes des autres. Les électrodes d et s, appelées électrodes principales, sont mobiles l'une par rapport à l'autre. Les électrodes g et r, appelées électrodes de commande, sont destinées à recevoir un signal de commande, par exemple une tension ou un courant, adapté à faire varier la position relative des électrodes d et s de façon à faire varier la valeur de la capacité Cds entre les électrodes d et s. Les électrodes principales d des condensateurs C1 et C2 sont connectées à un même noeud sup d'application d'une tension d'alimentation PC de la cellule. Les électrodes principales s des condensateurs C1 et C2 sont connectées à un même noeud out de fourniture d'un signal de sortie S de la cellule. L'électrode de commande g du condensateur C1 est connectée à un noeud in1 d'application d'un signal logique d'entrée A de la cellule, et l'électrode de commande g du condensateur C2 est connectée à un noeud in2 d'application d'un signal logique d'entrée B de la cellule. Les électrodes de commande r des condensateurs C1 et C2 sont connectées à un même noeud GND d'application d'un potentiel de référence de la cellule, par exemple la masse. Sur la figure 1, un condensateur $C_L$ connecté entre le noeud de sortie out et le noeud de référence GND a été représenté, schématisant la capacité de sortie de la cellule. Dans la cellule de la figure 1, les condensateurs C1 et C2 sont des condensateurs à variation positive de capacité, c'est-à-dire que la capacité de chaque condensateur entre ses électrodes principales d et s prend une valeur haute lorsque le signal appliqué entre ses électrodes de commande g et r est à une valeur haute, et prend une valeur basse lorsque le signal appliqué entre ses électrodes de commande g et r est à une valeur basse.

La cellule de la figure 1 se comporte comme un pont diviseur de tension capacitif comportant une capacité commandable correspondant à la capacité équivalente $C_{eq}$ = C1+C2 de l'association en parallèle des condensateurs C1 et C2, et une capacité fixe formée par la capacité $C_L$ du noeud de sortie out de la cellule. La tension de sortie de la cellule s'exprime comme suit :

$$S = PC \frac{C_{eq}}{C_{eq}+C_L} = PC \frac{C1+C2}{C1+C2+C_L}$$

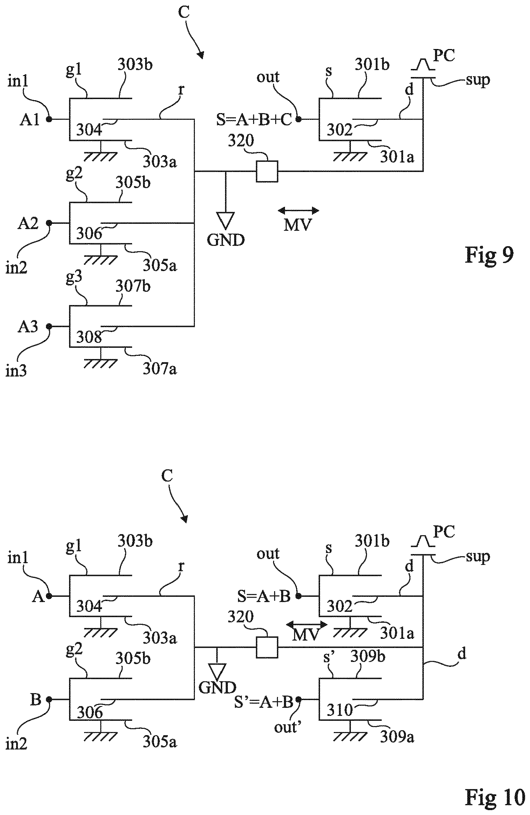

Lorsque les signaux d'entrée A et B sont à un état bas, les capacités des condensateurs C1 et C2 prennent des valeurs relativement basses $C1_{low}$ et $C2_{low}$ (par exemple $C1_{low}$ = $C2_{low}$) et le signal de sortie S est à un premier niveau de tension. Lorsque les signaux d'entrée A et B sont à un état haut, les capacités des condensateurs C1 et C2 prennent des valeurs relativement hautes $C1_{high}$ et $C2_{high}$ (par exemple $C1_{high}$ = $C2_{high}$) et le signal de sortie S est à un deuxième niveau de tension supérieur au premier niveau. Lorsque les signaux d'entrée A et B sont à des états distincts, par exemple A=1 et B=0, les capacités des condensateurs C1 et C2 prennent respectivement une valeur basse et une valeur haute, et le signal de sortie S est à un troisième niveau de tension compris entre les premier et deuxième niveaux. En considérant que les deuxième et troisième niveaux de tension correspondent à un état logique haut du signal S, et que le premier niveau de tension correspond à un état logique bas du signal S, la cellule de la figure 10 réalise une fonction logique OU (S=A+B).

Plus généralement, les demandes de brevet européen N°16204534 et américain N°15/381477 susmentionnées décrivent des exemples de cellules adaptées à mettre en oeuvre diverses fonctions logiques de base à deux entrées et une sortie binaires, et en particulier les fonctions logiques ET, NON ET et NON OU, à partir de deux condensateurs à capacité variable à quatre électrodes.

Le document US6242989B1 divulgue une capacité variable ayant cinq électrodes.

Il serait souhaitable d'améliorer au moins en partie certains aspects des cellules logiques capacitives du type décrit dans les demandes de brevet susmentionnées.

Résumé

Ainsi, un mode de réalisation prévoit une cellule logique capacitive telle que divulguée dans la revendication indépendante 1.

Selon un mode de réalisation, les premier et deuxième signaux logiques d'entrée sont référencés par rapport audit noeud d'application d'un premier potentiel de référence.

Selon un mode de réalisation, la cellule comporte en outre une sixième électrode isolée électriquement des première, deuxième, troisième, quatrième et cinquième électrodes, la sixième électrode étant connectée à un noeud d'application du deuxième potentiel de référence, le premier signal logique d'entrée étant référencé par rapport au noeud d'application d'un premier potentiel de référence et le deuxième signal logique d'entrée étant référencé par rapport au noeud d'application du deuxième potentiel de référence.

Selon un mode de réalisation, l'ensemble mobile est mobile en translation par rapport à l'ensemble fixe de façon à faire varier la surface de la deuxième électrode en vis-à-vis de la première électrode sans faire varier la distance entre les première et deuxième électrodes.

Selon un mode de réalisation, l'ensemble mobile est mobile en translation par rapport à l'ensemble fixe de façon à faire varier la distance entre les première et deuxième électrodes sans faire varier la surface de la deuxième électrode en vis-à-vis de la première électrode.

Selon un mode de réalisation, la cellule comporte un premier dispositif d'actionnement électrostatique apte à provoquer un déplacement de l'ensemble mobile par rapport à l'ensemble fixe en fonction de l'état du premier signal logique d'entrée, et un deuxième dispositif d'actionnement électrostatique apte à provoquer un déplacement de l'ensemble mobile par rapport à l'ensemble fixe en fonction de l'état du deuxième signal logique d'entrée.

Selon un mode de réalisation, la cellule comporte un dispositif d'actionnement électrostatique apte à provoquer un déplacement de l'ensemble mobile par rapport à l'ensemble fixe en fonction de l'état du premier signal logique d'entrée, et un dispositif d'actionnement électrodynamique apte à provoquer un déplacement de l'ensemble mobile par rapport à l'ensemble fixe en fonction de l'état du deuxième signal logique d'entrée.

Selon un mode de réalisation, la première électrode comprend des première et deuxième portions conductrices interconnectées, disposées de part et d'autre de la deuxième électrode de façon à limiter l'influence de la tension entre les première et deuxième électrodes sur la position de l'ensemble mobile par rapport à l'ensemble fixe.

Selon un mode de réalisation, la cellule comporte une septième électrode connectée à un noeud d'application d'un troisième signal logique d'entrée de la cellule, la position de la deuxième électrode par rapport à la première électrode étant fonction d'une combinaison des premier, deuxième et troisième signaux logiques d'entrée.

Selon un mode de réalisation, l'ensemble fixe comprend une huitième électrode isolée électriquement de la première électrode, les huitième et deuxième électrodes définissant une deuxième capacité variable en fonction de la position de l'ensemble mobile par rapport à l'ensemble fixe.

Selon un mode de réalisation, la huitième électrode est connectée à un noeud de fourniture d'un deuxième signal logique de sortie de la cellule.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, précédemment décrite, est un schéma électrique d'un exemple d'une cellule logique capacitive ;

la figure 2 est un schéma électrique d'un exemple d'un mode de réalisation d'une cellule logique capacitive ;

la figure 3 est une vue en coupe simplifiée d'un exemple d'un condensateur à capacité variable d'une cellule logique capacitive selon un mode de réalisation ;

la figure 4 est une vue en coupe simplifiée d'un autre exemple d'un condensateur à capacité variable d'une cellule logique capacitive selon un mode de réalisation ;

la figure 5 est une vue en coupe simplifiée d'un autre exemple d'un condensateur à capacité variable d'une cellule logique capacitive selon un mode de réalisation ;

la figure 6 est une vue en coupe simplifiée d'un autre exemple d'un condensateur à capacité variable d'une cellule logique capacitive selon un mode de réalisation ;

la figure 7 est une vue en coupe simplifiée d'un autre exemple d'un condensateur à capacité variable d'une cellule logique capacitive selon un mode de réalisation ;

la figure 8 est une vue en coupe simplifiée d'un autre exemple d'un condensateur à capacité variable d'une cellule logique capacitive selon un mode de réalisation ;

la figure 9 est une vue en coupe simplifiée d'un autre exemple d'un condensateur à capacité variable d'une cellule logique capacitive selon un mode de réalisation ;

la figure 10 est une vue en coupe simplifiée d'un autre exemple d'un condensateur à capacité variable d'une cellule logique capacitive selon un mode de réalisation ;

la figure 11 est une vue en coupe simplifiée d'un autre exemple d'un condensateur à capacité variable d'une cellule logique capacitive selon un mode de réalisation ;

la figure 12 est une vue en coupe simplifiée d'un autre exemple d'un condensateur à capacité variable d'une cellule logique capacitive selon un mode de réalisation ;

la figure 13 est une vue en coupe simplifiée d'un autre exemple d'un condensateur à capacité variable d'une cellule logique capacitive selon un mode de réalisation ; et

la figure 14 est une vue en coupe simplifiée d'un autre exemple d'un condensateur à capacité variable d'une cellule logique capacitive selon un mode de réalisation.

Description détaillée

De mêmes éléments ont été désignés par de mêmes références aux différentes figures et, de plus, les diverses figures ne sont pas tracées à l'échelle. Dans la présente description, on utilise le terme "connecté" pour désigner une liaison électrique directe, sans composant électronique intermédiaire, par exemple au moyen d'une ou plusieurs pistes conductrices, et le terme "couplé" ou le terme "relié", pour désigner une liaison qui peut être directe (signifiant alors "connecté") ou qui peut être réalisée par l'intermédiaire d'un ou plusieurs composants. Dans la description qui suit, lorsque l'on fait référence à des qualificatifs d'orientation, tels que les termes "horizontal", "vertical", etc., il est fait référence à l'orientation des figures, étant entendu que, en pratique, les dispositifs décrits peuvent être orientés différemment. Sauf précision contraire, les expressions "approximativement", "sensiblement", et "de l'ordre de" signifient à 10 % près, de préférence à 5 % près, ou, lorsqu'elles se rapportent à des valeurs d'angles ou à des orientations, à 10° près, de préférence à 5° près. Dans la présente description, on entend par plaque conductrice une plaque en un matériau apte à conduire des charges électriques, ce matériau pouvant être un matériau conducteur, par exemple un métal, ou encore un matériau semiconducteur, par exemple du silicium.

Contrairement aux cellules logiques classiques réalisées à base de transistors, dans lesquelles l'ensemble des opérations exploite des effets purement électriques (effet de champ électrique combiné à des jonctions semi-conductrices), les cellules logiques capacitives décrites dans la demande de brevet européen N°16204534 et dans la demande de brevet américain N°15/381477 susmentionnées (dont le contenu est ici incorporé par référence dans la mesure autorisée par la loi) codent des états logiques de façon mécanique (via une position relative entre les électrodes principales de chaque condensateur). Ce codage mécanique permet de se passer du compromis habituel en énergie, entre dissipation par conduction et dissipation par fuite, inhérent à toutes les cellules logiques à base de transistors. En contrepartie, la transduction électromécanique crée des pertes à chaque changement d'état logique.

Selon un aspect d'un mode de réalisation, pour réduire le nombre de composants et le nombre de transductions électromécaniques nécessaires à la mise en oeuvre d'une opération logique, on prévoit une cellule logique basée sur un unique condensateur à capacité variable à cinq électrodes, au lieu de deux condensateurs à capacité variable à quatre électrodes dans les demandes de brevet européen et américain susmentionnées.

La figure 2 est un schéma électrique d'un exemple d'un mode de réalisation d'une cellule logique capacitive. La cellule de la figure 2 comprend un condensateur à capacité variable C. Le condensateur C est un dispositif à cinq électrodes d, s, g1, g2 et r isolées électriquement les unes des autres. Les électrodes d et s, appelées électrodes principales, sont mobiles l'une par rapport à l'autre. Les électrodes g1, g2 et r, appelées électrodes de commande, sont destinées à recevoir des signaux de commande, par exemple des tensions ou des courants, adaptés à faire varier la position relative des électrodes d et s de façon à faire varier la valeur de la capacité Cds entre les électrodes d et s. Plus particulièrement, dans cet exemple, un premier signal de commande peut être appliqué entre les électrodes g1 et r et un deuxième signal de commande peut être appliqué entre les électrodes g2 et r, la position relative des électrodes d et s, et donc la capacité Cds du condensateur C, étant fonction d'une combinaison des premier et deuxième signaux de commande.

L'électrode principale d du condensateur C est connectée à un noeud sup d'application d'une tension d'alimentation PC de la cellule, par exemple une tension continue (dans le cas d'une implémentation d'un circuit logique statique dans lequel les états des signaux logiques sont disponibles à tout moment), ou, de préférence, une tension variable périodique (dans le cas d'une implémentation d'un circuit logique dynamique dans lequel les états des signaux logiques ne sont disponibles que pendant une partie de la période d'un signal d'horloge périodique tel que décrit dans les demandes de brevet européen N°16204534 et américain N°15/381477 susmentionnées), par exemple une tension trapézoïdale. L'électrode principale s du condensateur C est connectée à un noeud out de fourniture d'un signal logique de sortie S de la cellule. L'électrode de commande g1 du condensateur C est connectée à un noeud in1 d'application d'un signal logique d'entrée A de la cellule, et l'électrode de commande g2 du condensateur C est connectée à un noeud in2 d'application d'un signal logique d'entrée B de la cellule. L'électrode de commande r du condensateur C est connectée à un noeud GND d'application d'un potentiel de référence de la cellule, par exemple la masse. Sur la figure 2, un condensateur $C_L$ connecté entre le noeud de sortie out et le noeud de référence GND a en outre été représenté, schématisant la capacité de sortie de la cellule. En pratique, la capacité de sortie $C_L$ peut ne pas comprendre de composant spécifiquement réalisé et connecté au noeud de sortie out, mais correspondre à la somme des capacités des différents éléments connectés au noeud out, notamment des pistes d'interconnexion, ou encore à une autre cellule logique capacitive (non représentée) dont l'entrée peut être connectée au noeud out. Dans cet exemple, les signaux d'entrée A et B, le signal de sortie S et le signal d'alimentation PC de la cellule sont référencés par rapport au noeud GND.

La cellule de la figure 2 se comporte comme un pont diviseur de tension capacitif comportant une capacité commandable correspondant à la capacité Cds du condensateur C, et une capacité fixe formée par la capacité $C_L$ du noeud de sortie out de la cellule. La tension de sortie de la cellule s'exprime comme suit :

$$S = PC \frac{Cds}{Cds + C_L}$$

La capacité Cds du condensateur C étant fonction d'une combinaison des signaux logiques d'entrée A et B, la cellule réalise une opération logique S=f(A,B) au moyen d'un unique condensateur à capacité variable à cinq électrodes.

La fonction logique réalisée par la cellule dépend de l'agencement du condensateur à capacité variable C. Divers exemples de réalisation du condensateur à capacité variable C, adaptés pour la mise en oeuvre de diverses fonctions logiques de base, vont maintenant être décrits.

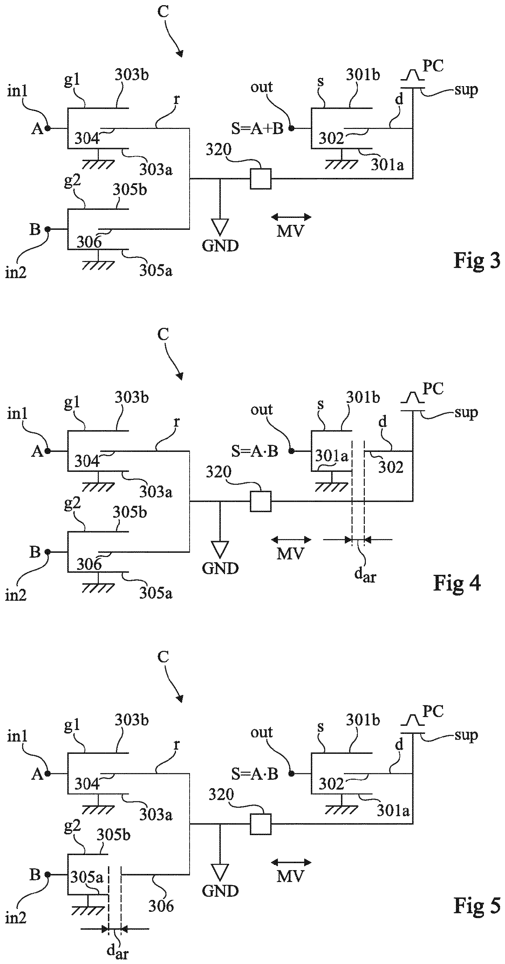

La figure 3 est une vue en coupe simplifiée d'un exemple de réalisation du condensateur à capacité variable C de la cellule de la figure 2, adapté pour la mise en oeuvre d'une opération logique OU.

Le condensateur C comprend deux ensembles mobiles l'un par rapport à l'autre, appelés ci-après respectivement ensemble fixe et ensemble mobile. Tous les éléments de l'ensemble fixe sont fixes les uns par rapport aux autres, et tous les éléments de l'ensemble mobile sont fixes les uns par rapport aux autres. Sur la figure 3 ainsi que sur les figures suivantes, on a représenté par des hachures obliques une masse mécanique, à laquelle sont fixés tous les éléments de l'ensemble fixe.

Dans l'exemple de la figure 3, les électrodes s, g1 et g2 font partie de l'ensemble fixe, et les électrodes d et r font partie de l'ensemble mobile. Le carré référencé 320 sur la figure 3 schématise une région électriquement isolante séparant les électrodes d et r de l'ensemble mobile.

L'électrode s comprend deux plaques conductrices 301a et 301b sensiblement horizontales et en vis-à-vis l'une de l'autre (c'est-à-dire sensiblement confondues en projection verticale), connectées électriquement au noeud de sortie out de la cellule. L'électrode g1 comprend deux plaques conductrices 303a et 303b sensiblement horizontales et en vis-à-vis l'une de l'autre, connectées électriquement au noeud d'entrée in1 de la cellule. L'électrode g2 comprend deux plaques conductrices 305a et 305b sensiblement horizontales et en vis-à-vis l'une de l'autre, connectés électriquement au noeud d'entrée in2 de la cellule. L'électrode d comprend une plaque conductrice 302 sensiblement horizontale, connectée électriquement au noeud d'alimentation sup de la cellule. L'électrode r comprend deux plaques conductrices 304 et 306 sensiblement horizontales, connectées électriquement au noeud de référence GND de la cellule.

L'ensemble fixe et l'ensemble mobile sont agencés de façon que les plaques conductrices 302, 304 et 306, soient disposées respectivement :

entre les plaques conductrices 301a et 301b, au moins partiellement en vis-à-vis des plaques conductrices 301a et 301b, sensiblement à équidistance des plaques conductrices 301a et 301b ;

entre les plaques conductrices 303a et 303b, au moins partiellement en vis-à-vis des plaques conductrices 303a et 303b, sensiblement à équidistance des plaques conductrices 303a et 303b ; et

entre les plaques conductrices 305a et 305b, au moins partiellement en vis-à-vis des plaques conductrices 305a et 305b, sensiblement à équidistance des plaques conductrices 305a et 305b.

Dans cet exemple, l'ensemble mobile est libre de se déplacer selon un unique degré de liberté en translation horizontale (parallèlement aux plaques conductrices 301a, 301b, 302, 303a, 303b, 304, 305a, 305b, 306) par rapport à l'ensemble fixe, de façon à modifier la surface de la plaque conductrice mobile 302, respectivement 304, respectivement 306 en vis-à-vis des plaques conductrices fixes correspondantes 301a et 301b, respectivement 303a et 303b, respectivement 305a et 305b, sans modifier la distance entre chaque plaque conductrice mobile et les plaques conductrices fixes correspondantes (mouvement représenté par une double flèche MV sur la figure). Plus particulièrement, dans l'exemple de la figure 3, l'ensemble fixe et l'ensemble mobile sont agencés de façon que lorsque la surface de l'une quelconque des plaques conductrices mobiles 302, 304 et 306 en vis-à-vis des plaques conductrices fixes correspondantes 301a et 301b, respectivement 303a et 303b, respectivement 305a et 305b augmente, la surface des autres plaques conductrices mobiles en vis-à-vis des plaques conductrices fixes correspondantes augmente, et inversement.

Le condensateur C de la figure 3 comporte en outre des moyens de rappel (non visibles sur la figure), par exemple un ressort de rappel, agencés pour, en l'absence de toute polarisation électrique des électrodes g1, g2, s et d par rapport à l'électrode r, ramener l'ensemble mobile dans une position (par rapport à l'ensemble fixe) dite de repos, dans laquelle les plaques conductrices mobiles 302, 304 et 306, sont seulement partiellement en vis-à-vis des plaques conductrices fixes correspondantes 301a et 301b, respectivement 303a et 303b, respectivement 305a et 305b (par exemple la position représentée sur la figure 3).

Au premier ordre, la capacité Cds du condensateur C entre ses électrodes principales s et d est proportionnelle à la surface de la plaque conductrice 302 en vis-à-vis des plaques conductrices 301a et 301b.

Dans l'exemple de la figure 3, les signaux logiques d'entrée A et B et de sortie S sont des tensions.

Lorsque les signaux d'entrée A et B sont à un état bas, c'est-à-dire à un niveau de tension inférieur (en valeur absolue) à un seuil $Vin_L$, par exemple à une tension sensiblement nulle, le condensateur C est dans sa position de repos, et la capacité Cds du condensateur C a une première valeur. Le signal de sortie S de la cellule a donc un premier niveau de tension Vout1.

Lorsque l'un des signaux d'entrée A et B est à un état haut, c'est-à-dire à une tension supérieure (en valeur absolue) à un seuil $Vin_H$ supérieur ou égal au seuil $Vin_L$, la plaque conductrice mobile 304 (si A=1 et B=0) ou 306 (si A=0 et B=1) est attirée entre les plaques conductrices fixes correspondantes 303a et 303b ou 305a et 305b, par interaction électrostatique. Ceci entraine un déplacement horizontal de l'ensemble mobile par rapport à l'ensemble fixe, tendant à augmenter la surface de la plaque conductrice mobile 304 ou 306 en vis-à-vis des plaques conductrices fixes correspondantes 303a et 303b ou 305a et 305b, et par conséquent la surface de la plaque conductrice mobile 302 en vis-à-vis des plaques conductrices fixes 301a et 301b. La capacité Cds du condensateur C prend ainsi une deuxième valeur supérieure à la première valeur. Le signal de sortie S de la cellule a alors un deuxième niveau de tension Vout2 supérieur (en valeur absolue) au premier niveau.

Lorsque les deux signaux d'entrée A et B sont à l'état haut, la force électrostatique exercée par les plaques conductrices 303a et 303b sur la plaque conductrice 304 et la force électrostatique exercée par les plaques conductrices 305a et 305b sur la plaque conductrice 306 s'ajoutent. Le déplacement horizontal de l'ensemble mobile par rapport à l'ensemble fixe est donc amplifié. La capacité Cds du condensateur C prend alors une troisième valeur supérieure à la deuxième valeur, et le signal de sortie S de la cellule a un troisième niveau de tension Vout3 supérieur (en valeur absolue) au deuxième niveau.

En considérant que les deuxième et troisième niveaux de tension Vout2 et Vout3 correspondent à un état logique haut du signal S, et que le premier niveau de tension Vout1 correspond à un état logique bas du signal S, le condensateur C de la figure 3 réalise bien une fonction OU (S=A+B).

A titre d'exemple, le condensateur C est dimensionné pour que l'état logique haut du signal de sortie S soit interprété comme un état logique haut lorsqu'il est appliqué sur l'entrée in1 ou in2 de la cellule, et pour que l'état logique bas du signal de sortie S soit interprété comme un état logique bas lorsqu'il est appliqué sur l'entrée in1 ou in2 de la cellule. Ceci permet de pouvoir cascader directement plusieurs cellules logiques capacitives identiques ou similaires, sans nécessiter des circuits d'adaptation de niveau à l'interface entre les différentes cellules. A titre d'exemple, le condensateur C de la figure 3 est dimensionné pour que les niveaux de tension de sortie Vout2 et Vout3 soient supérieurs au seuil $Vin_H$, et pour que le niveau de tension de sortie Vout1 soit inférieur au seuil $Vin_L$.

La figure 4 est une vue en coupe simplifiée d'un autre exemple de réalisation du condensateur à capacité variable C de la cellule de la figure 2, adapté pour la mise en oeuvre d'une opération logique ET.

Le condensateur C de la figure 4 diffère du condensateur C de la figure 3 principalement en ce que, dans l'exemple de la figure 4, dans la position de repos du condensateur, les plaques conductrices 302 d'une part, et 301a et 301b d'autre part, ne se recouvrent pas. Autrement dit, dans la position de repos, la plaque conductrice 302 n'est pas en vis-à-vis des plaques conductrices 301a et 301b. Plus particulièrement, dans la position de repos, en projection verticale, une distance de non recouvrement $d_{ar}$ sépare la plaque conductrice 302 des plaques conductrices 301a et 301b.

Pour le reste, le condensateur C de la figure 4 est identique ou similaire au condensateur C de la figure 3.

Lorsque les signaux d'entrée A et B sont à l'état bas, du fait du non recouvrement de la plaque conductrice mobile 302 et des plaques conductrices fixes correspondantes 301a et 301b, la capacité Cds du condensateur est nulle ou négligeable. Le signal de sortie S de la cellule a donc un niveau de tension nul ou négligeable, correspondant à un état logique bas du signal S.

Lorsque l'un seulement des signaux d'entrée A et B est à l'état haut, la plaque conductrice mobile correspondante 304 ou 306 est attirée entre les plaques conductrices fixes correspondantes 303a et 303b ou 305a et 305b, par interaction électrostatique. Ceci entraine un déplacement horizontal de l'ensemble mobile par rapport à l'ensemble fixe, tendant à réduire la distance de non recouvrement $d_{ar}$ entre la plaque conductrice 302 et les plaques conductrices 301a et 301b, sans toutefois l'annuler. Ainsi, la capacité Cds du condensateur reste nulle ou négligeable, et le signal de sortie S de la cellule reste à l'état bas.

Lorsque les signaux d'entrée A et B sont tous les deux à l'état haut, le déplacement horizontal de l'ensemble mobile par rapport à l'ensemble fixe est amplifié, et la plaque conductrice 302 pénètre entre les plaques conductrices 301a et 301b. La capacité Cds du condensateur C prend alors une valeur non négligeable, et le signal de sortie S de la cellule prend un niveau de tension non négligeable, correspondant à un état logique haut du signal S.

Ainsi, le condensateur C de la figure 4 réalise bien une fonction ET (S=A.B).

La figure 5 est une vue en coupe simplifiée d'un autre exemple de réalisation du condensateur à capacité variable C de la cellule de la figure 2, adapté pour la mise en oeuvre d'une opération logique ET.

Le condensateur C de la figure 5 diffère du condensateur C de la figure 3 principalement en ce que, dans l'exemple de la figure 5, dans la position de repos du condensateur, les plaques conductrices 306 d'une part, et 305a et 305b d'autre part, ne se recouvrent pas. Autrement dit, dans la position de repos, la plaque conductrice 306 n'est pas en vis-à-vis des plaques conductrices 305a et 305b. Plus particulièrement, dans la position de repos, en projection verticale, une distance de non recouvrement $d_{ar}$ sépare la plaque conductrice 306 des plaques conductrices 305a et 305b.

Pour le reste, le condensateur C de la figure 5 est identique ou similaire au condensateur C de la figure 3.

Lorsque le signal A est à l'état bas, le condensateur C reste dans sa position de repos indépendamment de l'état du signal B. En particulier, même si le signal B est à l'état haut, la force électrostatique exercée sur la plaque conductrice 306 par les plaques conductrices 305a et 305b est négligeable en raison du non recouvrement des électrodes 306 et 305a, 305b. La capacité Cds du condensateur C a alors une première valeur, et le signal de sortie S de la cellule un premier niveau de tension correspondant à un état logique bas du signal S.

Lorsque le signal A est à l'état haut, la force électrostatique exercée sur la plaque conductrice mobile 304 par les plaques conductrices fixes 303a et 303b entraine un déplacement horizontal de l'ensemble mobile par rapport à l'ensemble fixe, tendant à augmenter la surface de la plaque conductrice 304 en vis-à-vis des plaques conductrices 303a et 303b. Ceci conduit à augmenter la surface de la plaque conductrice 302 en vis-à-vis des plaques conductrices 301a et 301b, et à faire pénétrer la plaque conductrice 306 entre les plaques conductrices 305a et 305b. Si le signal B est à l'état bas, la capacité Cds du condensateur C a alors une deuxième valeur supérieure à la première valeur, et le signal de sortie S de la cellule a un deuxième niveau de tension supérieur (en valeur absolue) au premier niveau, correspondant toujours à l'état logique bas du signal S. Si en revanche le signal B est à l'état haut, la force électrostatique exercée sur la plaque conductrice 306 par les plaques conductrices 305a et 305b tend à amplifier le déplacement horizontal de l'ensemble mobile par rapport à l'ensemble fixe, conduisant à augmenter la surface de la plaque conductrice 302 en vis-à-vis des plaques conductrices 301a et 301b. La capacité Cds du condensateur C a alors une troisième valeur supérieure à la deuxième valeur, et le signal de sortie S de la cellule a un troisième niveau de tension supérieur (en valeur absolue) au deuxième niveau, correspondant à l'état logique haut du signal S.

Ainsi, le condensateur C de la figure 5 réalise bien une fonction ET (S=A.B).

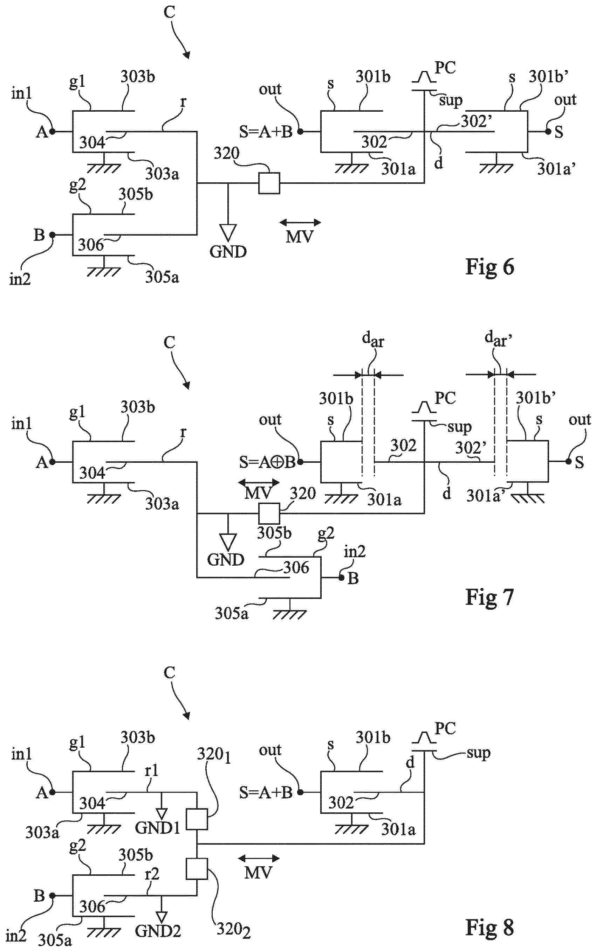

La figure 6 est une vue en coupe simplifiée d'un autre exemple de réalisation du condensateur à capacité variable C de la cellule de la figure 2, adapté pour la mise en oeuvre d'une opération logique OU.

Le condensateur C de la figure 6 comprend les mêmes éléments que le condensateur C de la figure 5, agencés sensiblement de la même manière.

Dans l'exemple de la figure 6, l'électrode d du condensateur comprend une plaque conductrice supplémentaire 302' sensiblement horizontale, fixe par rapport à la plaque conductrice 302, et connectée électriquement à la plaque conductrice 302.

De plus, dans cet exemple, l'électrode s du condensateur comprend deux plaques conductrices supplémentaires 301a' et 301b' sensiblement horizontales et en vis-à-vis l'une de l'autre, fixes par rapport aux plaques conductrices 301a et 301b, et connectées électriquement aux plaques conductrices 301a et 301b.

L'ensemble fixe et l'ensemble mobile sont agencés de façon que la plaque conductrice 302' soit disposée entre les plaques conductrices 301a' et 301b', au moins partiellement en vis-à-vis des plaques conductrices 301a' et 301b', sensiblement à équidistance des plaques conductrices 301a' et 301b'.

Plus particulièrement, dans l'exemple de la figure 6, l'ensemble fixe et l'ensemble mobile sont agencés de façon que lorsque la surface de la plaque conductrice 302 en vis-à-vis des plaques conductrices 301a et 301b augmente, la surface de la plaque conductrice 302' en vis-à-vis des plaques conductrices 301a' et 301b' diminue, et inversement.

Il en résulte que lorsqu'une tension non nulle est appliquée entre les électrodes d et s du condensateur, la force électrostatique exercée par les plaques conductrices 301a' et 301b' sur la plaque conductrice 302' s'oppose à la force électrostatique exercée par les plaques conductrices 301a et 301b sur la plaque conductrice 302. Ceci permet de limiter l'influence de la tension Uds entre les électrodes d et s du condensateur sur la valeur de la capacité Cds, voire de supprimer l'influence de la tension Uds sur la capacité Cds lorsque la surface de la plaque conductrice 302 en vis-à-vis des plaques conductrices 301a et 301b est égale à la surface de la plaque conductrice 302' en vis-à-vis des plaques conductrices 301a' et 301b' (configuration représentée sur la figure 6, correspondant par exemple à la position de repos du condensateur).

On notera que, dans cet exemple, pour autoriser une variation de la capacité entre les électrodes principales d et s du dispositif, il convient que le déplacement latéral soit suffisant pour que la plaque 302' ne soit plus en vis-à-vis des plaques 301a', 301b', de façon que la diminution de la capacité entre les plaques 302' et 301a', 301b' ne soit plus compensée par l'augmentation de la capacité entre les plaques 302 et 301a, 301b. Autrement dit, il convient que le déplacement lié à l'application des signaux d'entrée A et B soit supérieur au recouvrement initial entre les plaques 302' et 301a', 301b'.

La figure 7 est une vue en coupe simplifiée d'un autre exemple de réalisation du condensateur à capacité variable C de la cellule de la figure 2, adapté pour la mise en oeuvre d'une opération logique OU EXCLUSIF.

Le condensateur C de la figure 7 comprend des éléments communs avec le condensateur C de la figure 6. Seules les différences entre les deux condensateurs seront détaillées par la suite.

Le condensateur C de la figure 7 diffère du condensateur C de la figure 6 en ce que, dans l'exemple de la figure 7, dans la position de repos du condensateur, les plaques conductrices 302 d'une part, et 301a et 301b d'autre part, ne se recouvrent pas. De plus, dans la position de repos du condensateur, les plaques conductrices 302' d'une part, et 301a' et 301b' d'autre part, ne se recouvrent pas. Plus particulièrement, dans la position de repos, en projection verticale, une distance de non recouvrement $d_{ar}$ sépare la plaque conductrice 302 des plaques conductrices 301a et 301b, et une distance de non recouvrement $d_{ar}$', par exemple sensiblement identique, sépare la plaque conductrice 302' des plaques conductrices 301a' et 301b'.

Une autre différence entre le condensateur C de la figure 7 et le condensateur C de la figure 6 est que, dans l'exemple de la figure 7, l'ensemble fixe et l'ensemble mobile sont agencés de façon que lorsque la surface de la plaque conductrice mobile 304 en vis-à-vis des plaques conductrices fixes 303a et 303b augmente :

la distance de non recouvrement $d_{ar}$ entre la plaque conductrice 302 et les plaques conductrices 301a et 301b diminue, ou la surface de la plaque conductrice 302 en vis-à-vis des plaques conductrices 301a et 301b augmente ;
la distance de non recouvrement $d_{ar}$' entre la plaque conductrice 302' et les plaques conductrices 301a' et 301b' augmente, ou la surface de la plaque conductrice 302' en vis-à-vis des plaques conductrices 301a' et 301b' diminue ; et
la surface de la plaque conductrice 306 en vis-à-vis des plaques conductrices 305a et 305b diminue, et inversement.

Lorsque les signaux d'entrée A et B sont à un état bas, le condensateur C est dans sa position de repos. Du fait du non recouvrement entre la plaque conductrice 302 et les plaques conductrices 301a, 301b d'une part, et entre la plaque conductrice 302' et les plaques conductrices 301a' et 301b' d'autre part, la capacité Cds du condensateur C est nulle ou négligeable. Le signal de sortie S de la cellule a donc un niveau de tension nul ou négligeable, correspondant à un état logique bas du signal S.

Lorsque les signaux d'entrée A et B sont à un état haut, la force électrostatique exercée par les plaques conductrices 303a et 303b sur la plaque conductrice 304 compense la force électrostatique exercée par les plaques conductrices 305a et 305b sur la plaque conductrice 306, de sorte que le condensateur C reste dans sa position de repos. Le signal de sortie S de la cellule reste donc à l'état bas du signal S.

Lorsque les signaux d'entrée A et B sont respectivement à un état haut et à un état bas, la force électrostatique exercée par les plaques conductrices 303a et 303b sur la plaque conductrice 304 entraine un déplacement horizontal de l'ensemble mobile par rapport à l'ensemble fixe, tendant à augmenter la surface de la plaque conductrice 304 en vis-à-vis des plaques conductrices 303a et 303b. Il en résulte que la plaque conductrice 302 pénètre entre les plaques conductrices 301a et 301b. La capacité Cds du condensateur C prend alors une valeur non négligeable, et le signal de sortie S de la cellule prend un niveau de tension non négligeable, correspondant à un état logique haut du signal S.

De façon similaire, lorsque les signaux d'entrée A et B sont respectivement à un état bas et à un état haut, la force électrostatique exercée par les plaques conductrices 305a et 305b sur la plaque conductrice 306 entraine un déplacement horizontal de l'ensemble mobile par rapport à l'ensemble fixe, tendant à augmenter la surface de la plaque conductrice 306 en vis-à-vis des plaques conductrices 305a et 305b. Il en résulte que la plaque conductrice 302' pénètre entre les plaques conductrices 301a' et 301b'. La capacité Cds du condensateur C prend alors une valeur non négligeable, et le signal de sortie S de la cellule prend un niveau de tension non négligeable, correspondant à un état logique haut du signal S.

Ainsi, le condensateur C de la figure 7 réalise bien une fonction OU EXCLUSIF ($S=A\oplus B$).

La figure 8 est une vue en coupe simplifiée d'un autre exemple de réalisation d'un condensateur à capacité variable C adapté pour la mise en oeuvre d'une opération logique OU.

Le condensateur de la figure 8 diffère des exemples précédents en ce qu'il comprend six électrodes isolées électriquement les unes des autres, au lieu de cinq dans les exemples précédents. Plus particulièrement, dans le condensateur de la figure 8, l'électrode r est remplacée par deux électrodes r1 et r2 isolées électriquement l'une de l'autre, chacune des électrodes r1 et r2 étant isolée électriquement des électrodes d, s, g1 et g2. Les électrodes du condensateur C de la figure 8 sont par exemple connectées de façon similaire ou identique à ce qui a été décrit précédemment, à la différence près que l'électrode r1 et l'électrode r2 sont connectées à des noeuds GND1 et GDN2 d'application de potentiels de référence distincts. Un premier signal de commande peut être appliqué entre les électrodes g1 et r1 et un deuxième signal de commande peut être appliqué entre les électrodes g2 et r2, la position relative des électrodes d et s, et donc la capacité Cds du condensateur C, étant fonction d'une combinaison des premier et deuxième signaux de commande. Dans cet exemple, les électrodes r1 et r2 font partie de l'ensemble mobile du condensateur C. Sur la figure 8, le carré référencé $320_1$ schématise une région électriquement isolante séparant l'électrode r1 des électrodes d et r2 de l'ensemble mobile, et le carré référencé $320_2$ schématise une région électriquement isolante séparant l'électrode r2 des électrodes d et r1.

Le condensateur C de la figure 8 comprend les mêmes éléments que le condensateur C de la figure 3, agencés sensiblement de la même manière, et diffère du condensateur C de la figure 3 essentiellement en ce que, dans l'exemple de la figure 8, les plaques conductrices 304 et 306 sont isolées électriquement l'une de l'autre. La plaque conductrice 304 est connectée au noeud GND1 et forme l'électrode r1 du condensateur, et la plaque conductrice 306 est connectée au noeud GND2 et forme l'électrode r2 du condensateur.

Un avantage du condensateur C de la figure 8 est qu'il permet de réaliser une opération logique portant sur des signaux référencés par rapport à des potentiels distincts.

La figure 9 est une vue en coupe simplifiée d'un autre exemple de réalisation d'un condensateur à capacité variable C adapté pour la mise en oeuvre d'une opération logique OU. A la différence des exemples décrits précédemment dans lesquels le condensateur C permet de réaliser des opérations logiques à deux entrées et une sortie, le condensateur C de la figure 9 permet de réaliser une opération logique à trois entrées et une sortie.

Le condensateur C de la figure 9 comprend les mêmes éléments que le condensateur C de la figure 3, agencés sensiblement de la même manière. Le condensateur C de la figure 9 comprend de plus une électrode de commande supplémentaire g3, isolée électriquement des électrodes d, s, g1, g2 et r. Dans cet exemple, l'électrode g3 fait partie de l'ensemble fixe du condensateur.

Dans l'exemple de la figure 9, l'électrode g3 comprend deux plaques conductrices 307a et 307b sensiblement horizontales et en vis-à-vis l'une de l'autre, connectées électriquement à un troisième noeud d'entrée in3 de la cellule.

De plus, dans cet exemple, l'électrode r comprend une plaque conductrice supplémentaire 308 sensiblement horizontale, connectée électriquement au noeud de référence GND de la cellule.

L'ensemble fixe et l'ensemble mobile sont agencés de façon que la plaque conductrice 308 soit disposée entre les plaques conductrices 307a et 307b, au moins partiellement en vis-à-vis des plaques conductrices 307a et 307b, sensiblement à équidistance des plaques conductrices 307a et 307b. Plus particulièrement, dans l'exemple de la figure 9, l'ensemble fixe et l'ensemble mobile sont agencés de façon que lorsque la surface de la plaque conductrice 308 en vis-à-vis des plaques conductrices 307a et 307b augmente, la surface de la plaque conductrice 302 en vis-à-vis des plaques conductrices 301a et 301b augmente, et inversement.

Dans cet exemple, les noeuds in1, in2 et in3 du condensateur C sont destinés à recevoir respectivement des signaux logiques d'entrée A1, A2 et A3.

Lorsque les signaux d'entrée A1, A2 et A3 sont à l'état bas, le condensateur C est dans sa position de repos, et la capacité Cds du condensateur C a une première valeur. Le signal de sortie S de la cellule a donc un premier niveau de tension Vout1.

Lorsque l'un des signaux d'entrée A1, A2 et A3 est à l'état haut, un déplacement horizontal de l'ensemble mobile par rapport à l'ensemble fixe se produit, tendant à augmenter la surface de la plaque conductrice 302 en vis-à-vis des plaques conductrices 301a et 301b. La capacité Cds du condensateur C prend ainsi une deuxième valeur supérieure à la première valeur, et le signal de sortie S de la cellule prend un deuxième niveau de tension Vout2 supérieur (en valeur absolue) au premier niveau.

Lorsque deux des signaux d'entrée A1, A2 et A3 sont à l'état haut, le déplacement horizontal de l'ensemble mobile par rapport à l'ensemble fixe est amplifié, et la capacité Cds du condensateur C prend une troisième valeur supérieure à la deuxième valeur. Le signal de sortie S de la cellule prend alors un troisième niveau de tension Vout3 supérieur (en valeur absolue) au deuxième niveau.

Lorsque les signaux d'entrée A1, A2 et A3 sont tous les trois à l'état haut, le déplacement horizontal de l'ensemble mobile par rapport à l'ensemble fixe est encore amplifié, et la capacité Cds du condensateur C prend une quatrième valeur supérieure à la troisième valeur. Le signal de sortie S de la cellule prend alors un quatrième niveau de tension Vout4 supérieur (en valeur absolue) au troisième niveau.

En considérant que les deuxième, troisième et quatrième niveaux de tension Vout2, Vout3 et Vout4 correspondent à un état logique haut du signal S, et que le premier niveau de tension Vout1 correspond à un état logique bas du signal S, le condensateur C de la figure 3 réalise bien une fonction OU (S=A1+A2+A3).

Plus généralement, l'homme du métier saura adapter les exemples décrits pour réaliser des fonctions logiques à N entrées et une sortie, où N est un entier quelconque supérieur ou égal à 2.

La figure 10 est une vue en coupe simplifiée d'un autre exemple de réalisation d'un condensateur à capacité variable C adapté pour la mise en oeuvre d'une opération logique OU. A la différence des exemples décrits précédemment dans lesquels le condensateur C permet de réaliser des opérations logiques à N entrées et une sortie, le condensateur C de la figure 9 permet de réaliser une opération logique à N entrées et deux sorties.

Le condensateur C de la figure 10 comprend les mêmes éléments que le condensateur C de la figure 3, agencés sensiblement de la même manière. Le condensateur C de la figure 10 comprend de plus une électrode principale supplémentaire s', isolée électriquement des électrodes s, d, g1, g2 et r. Dans cet exemple, l'électrode s' fait partie de l'ensemble fixe du condensateur.

Dans l'exemple de la figure 10, l'électrode s' comprend deux plaques conductrices supplémentaires 309a et 309b sensiblement horizontales et en vis-à-vis l'une de l'autre, connectées électriquement à un deuxième noeud de sortie out' de la cellule.

De plus, dans cet exemple, l'électrode d comprend une plaque conductrice supplémentaire 310 sensiblement horizontale, connectée électriquement au noeud d'alimentation sup de la cellule.

L'ensemble fixe et l'ensemble mobile sont agencés de façon que la plaque conductrice 310 soit disposée entre les plaques conductrices 309a et 309b, au moins partiellement en vis-à-vis des plaques conductrices 309a et 309b, sensiblement à équidistance des plaques conductrices 309a et 309b. Plus particulièrement, dans l'exemple de la figure 10, l'ensemble fixe et l'ensemble mobile sont agencés de façon que lorsque la surface de la plaque conductrice 302 en vis-à-vis des plaques conductrices 301a et 301b augmente, la surface de la plaque conductrice 310 en vis-à-vis des plaques conductrices 309a et 309b augmente, et inversement.

Les noeuds out et out' sont destinés à fournir respectivement des signaux logiques de sortie S et S'.

Dans cet exemple, la capacité Cds' du condensateur entre les électrodes d et s' évolue sensiblement de la même manière que la capacité Cds du condensateur entre les électrodes d et s.

Ainsi, le signal logique de sortie S' fourni sur le noeud de sortie out' est une image du signal logique de sortie S fourni sur le noeud de sortie out.

Un avantage de cette configuration est qu'elle permet de fournir le résultat de la combinaison logique des signaux A et B sur deux noeuds de sortie distincts isolés électriquement l'un de l'autre.

Plus généralement, l'homme du métier saura adapter les exemples décrits pour réaliser des fonctions logiques à N entrées et M sorties, où M est un entier quelconque supérieur ou égal à 1.

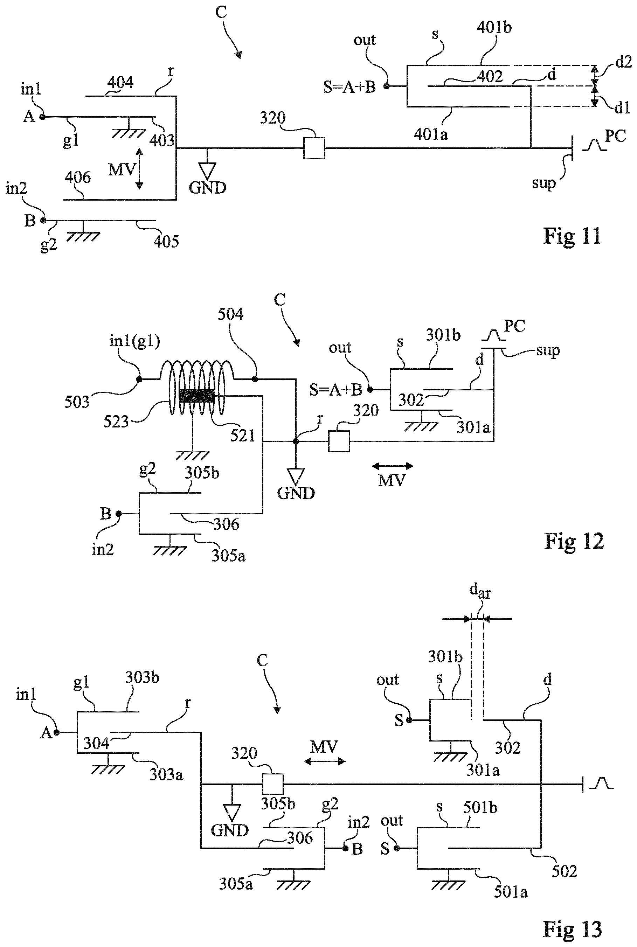

La figure 11 est une vue en coupe simplifiée d'un autre exemple de réalisation du condensateur à capacité variable C de la cellule de la figure 2, adapté pour la mise en oeuvre d'une opération logique OU. Le condensateur C de la figure 11 comprend des éléments communs avec le condensateur C de la figure 3. Seules les différences entre les deux condensateurs seront détaillées ci-après.

Dans l'exemple de la figure 11, l'électrode s du condensateur comprend deux plaques conductrices 401a et 401b sensiblement horizontales et en vis-à-vis l'une de l'autre, connectées électriquement au noeud de sortie out de la cellule. L'électrode g1 du condensateur comprend une plaque conductrice 403 sensiblement horizontale, connectée électriquement au noeud d'entrée in1 de la cellule. L'électrode g2 du condensateur comprend une plaque conductrice 405 sensiblement horizontale, connectée électriquement au noeud d'entrée in2 de la cellule. L'électrode d du condensateur comprend une plaque conductrice 402 sensiblement horizontale, connectée électriquement au noeud d'alimentation sup de la cellule. L'électrode r de la cellule comprend deux plaques conductrices 404 et 406 sensiblement horizontales, connectées électriquement au noeud de référence GND de la cellule.

L'ensemble fixe et l'ensemble mobile sont agencés de façon que la plaque conductrice 402, 404 et 406, soient disposées respectivement :

> entre les plaques conductrices 401a et 401b, au moins partiellement en vis-à-vis des plaques conductrices 401a et 401b ;
> au moins partiellement en vis-à-vis de la plaque conductrice 403 ; et
> au moins partiellement en vis-à-vis de la plaque conductrice 405.

Dans cet exemple, l'ensemble mobile est libre de se déplacer selon un unique degré de liberté en translation verticale (orthogonalement aux plaques conductrices 401a, 401b, 402, 403, 404, 405, 406) par rapport à l'ensemble fixe (mouvement représenté par une double flèche MV sur la figure), de façon à modifier la distance entre la plaque conductrice mobile 402 et les plaques conductrices fixes 401a et 401b, la distance entre la plaque conductrice mobile 404 et la plaque conductrice fixe 403, et la distance entre la plaque conductrice mobile 406 et la plaque conductrice fixe 405, sans modifier la surface de la plaque conductrice mobile 402 en vis-à-vis des plaques conductrices fixes 401a et 401b, la surface de la plaque conductrice mobile 404 en vis-à-vis de la plaque conductrice fixe 403, et la surface de la plaque conductrice mobile 406 en vis-à-vis de la plaque conductrice fixe 405. Plus particulièrement, dans l'exemple de la figure 11, l'ensemble fixe et l'ensemble mobile sont agencés de façon que lorsque la distance entre l'une quelconque des plaques conductrices mobiles 402, 404 et 406 et la plaque conductrice fixe correspondante 401a, respectivement 403, respectivement 405 augmente, la distance entre les autres plaques conductrices mobiles et les plaques conductrices fixes augmente de la même valeur, et inversement. On notera de plus que dans cet exemple, lorsque la distance entre la plaque conductrice 402 et la plaque conductrice 401a augmente, la distance entre la plaque conductrice 402 et la plaque conductrice 401b diminue, et inversement.

Le condensateur C peut en outre comporter des moyens de rappel (non visibles sur la figure), par exemple un ressort de rappel, agencé pour, en l'absence de toute polarisation électrique des électrodes g1, g2, s et d par rapport à l'électrode r, ramener l'ensemble mobile dans une position dite de repos, par exemple une position dans laquelle la plaque conductrice mobile 402 est située à équidistance des plaques conductrices fixes 401a et 401b (correspondant à la position représentée sur la figure 11).

Bien que non représenté sur la figure 11, le condensateur C comporte en outre une ou plusieurs butées agencées pour éviter que les plaques conductrices 404 et 403, respectivement 406 et 405, respectivement 402 et 401a ne se collent l'une à l'autre. A titre d'exemple, ces butées peuvent prendre la forme :

> d'une première couche isolante revêtant la face supérieure de la plaque 403 ou la face inférieure de la plaque 404 ;
> d'une deuxième couche isolante revêtant la face supérieure de la plaque 405 ou la face inférieure de la plaque 406 ; et
> d'une troisième couche isolante revêtant la face supérieure de la plaque 401a ou la face inférieure de la plaque 402.

Au premier ordre, la capacité Cds du condensateur C entre ses électrodes principales s et d est égale à la somme d'une capacité Cds1 formée entre la plaque conductrice 401a et la plaque conductrice 402, et d'une capacité Cds2 formée entre la plaque conductrice 401b et la plaque conductrice 402, les capacités Cds1 et Cds2 étant respectivement inversement proportionnelle à la distance d1 entre les plaques 401a et 402 et inversement proportionnelle à la distance d2 entre les plaques 401b et 402. Ainsi, la capacité Cds prend une valeur minimale lorsque la plaque conductrice 402 est à équidistance des plaques conductrices 401a et 401b.

Lorsque les signaux de commande A et B sont à l'état bas, le condensateur C est dans sa position de repos, et la capacité Cds du condensateur C a une première valeur, correspondant ici à sa valeur minimale. Le signal de sortie S de la cellule a donc un premier niveau de tension Vout1 relativement bas.

Lorsque l'un des signaux d'entrée A et B est à un état haut, la plaque conductrice mobile 404 (si A=1 et B=0) ou 406 (si A=0 et B=1) est attirée vers la plaque conductrice fixe correspondante 403 ou 405, par interaction électrostatique. Ceci entraine un déplacement vertical de l'ensemble mobile par rapport à l'ensemble fixe, tendant à diminuer la distance d1 entre la plaque conductrice mobile 402 et la plaque conductrice fixe 401a. Plus particulièrement, la plaque conductrice mobile 402 vient se plaquer contre la plaque conductrice 401a, à une distance de la plaque conductrice 401a fixée par la ou les butées du condensateur. La capacité Cds du condensateur C prend ainsi une deuxième valeur supérieure à la première valeur. Le signal de sortie S de la cellule a alors un deuxième niveau de tension Vout2 supérieur (en valeur absolue) au premier niveau.

Lorsque les deux signaux d'entrée A et B sont à l'état haut, le déplacement vertical de l'ensemble mobile par rapport à l'ensemble fixe est similaire, c'est-à-dire que la plaque conductrice mobile 402 vient se plaquer contre la plaque conductrice 401a, à une distance de la plaque conductrice 401a fixée par la ou les butées du condensateur. La capacité Cds du condensateur C prend alors la deuxième valeur, et le signal de sortie S de la cellule est au deuxième niveau de tension Vout2.

En considérant que le deuxième niveau de tension Vout2 correspond à un état logique haut du signal S, et que le premier niveau de tension Vout1 correspond à un état logique bas du signal S, le condensateur C de la figure 11 réalise bien une fonction OU (S=A+B).

On notera que dans l'exemple de la figure 11, l'électrode s comprend deux plaques conductrices 401a et 401b disposées de part et d'autre de la plaque conductrice 402 formant l'électrode d. Ceci permet avantageusement de réduire l'influence de la tension Uds entre les électrodes s et d sur la valeur de la capacité Cds, voire d'annuler l'influence de la tension Uds sur la valeur de la capacité Cds lorsque la plaque conductrice 402 est à équidistance des plaques conductrices 401a et 401b.

A titre de variante, l'une des plaques conductrices 401a et 401b peut être omise. On notera que dans cet exemple, si la plaque conductrice 401b est omise et la plaque conductrice 401a conservée, la fonction logique réalisée est une fonction OU, et, si la plaque conductrice 401a est omise et la plaque conductrice 401b conservée, la fonction logique réalisée est une fonction NON OU.

Plus généralement, l'homme du métier saura adapter la structure décrite en relation avec la figure 11 pour mettre en oeuvre diverses fonctions logiques de base (ET, OU EXCLUSIF, etc.) en faisant varier la distance entre les électrodes principales d et s du condensateur en fonction d'une combinaison des signaux logiques d'entrée appliqués sur les électrodes de commande.

La figure 12 est une vue en coupe simplifiée d'un autre exemple de réalisation du condensateur à capacité variable C de la cellule de la figure 2, adapté pour la mise en oeuvre d'une opération logique OU.

Le condensateur C de la figure 12 comprend des éléments communs avec le condensateur C de la figure 3. Dans la suite, seules les différences entre les deux structures seront détaillées.

Le condensateur C de la figure 12 diffère du condensateur C de la figure 3 principalement en ce qu'il met en oeuvre un actionnement de type électromagnétique, aussi appelé électrodynamique, combiné avec un actionnement de type électrostatique, au lieu d'un actionnement purement électrostatique comme dans l'exemple de la figure 3.

Plus particulièrement, dans l'exemple de la figure 12, les plaques conductrices 303a, 303b et 304 sont remplacées par un ensemble comprenant :

une borne conductrice 503, correspondant à l'électrode g1 du condensateur et connectée électriquement au noeud d'entrée in1 de la cellule ;
une borne conductrice 504, connectée électriquement à la plaque conductrice 306 ;
une bobine conductrice 521 dont une première extrémité est connectée électriquement à la borne 503 et dont une deuxième extrémité est connectée à la borne 504 ; et
un aimant 523 disposé à l'intérieur de la bobine 521.

Dans cet exemple, les bornes 503 et 504 et la bobine 521 font partie de l'ensemble fixe du condensateur, et l'aimant 523 est un élément de l'ensemble mobile du condensateur. Autrement dit, les bornes 503 et 504 et la bobine 521 sont fixes par rapport aux plaques conductrices 301a, 301b, 305a et 305b, et l'aimant 523 est fixe par rapport aux plaques conductrices 306 et 302. Dans cet exemple, l'axe central de la bobine 521 est sensiblement horizontal.

L'application d'un courant de commande dans la bobine 521 par l'intermédiaire des électrodes g1 et r entraine un déplacement de l'aimant 523 le long de l'axe central de la bobine. Il en résulte une variation de la surface de la plaque conductrice mobile 302 en vis-à-vis des plaques conductrices fixes 301a et 301b, et donc une variation de la capacité Cds du condensateur C.

La structure de la figure 12 présente l'avantage de permettre de réaliser une opération logique ayant pour opérandes des signaux électriques de natures distinctes, à savoir un signal logique A en courant et un signal logique B en tension dans l'exemple représenté.

A titre de variante, la structure peut être modifiée pour remplacer le mécanisme d'actionnement électrostatique associé à l'électrode g2 par un mécanisme d'actionnement électrodynamique, de façon à réaliser un condensateur à actionnement purement électrodynamique.

La figure 13 est une vue en coupe simplifiée d'un autre exemple de réalisation d'un condensateur à capacité variable C, adapté pour la mise en oeuvre successive de deux opérations logiques distinctes à une entrée et une sortie, une opération OUI (buffer) et une opération NON (inverseur), pour deux entrées distinctes.

Le condensateur C de la figure 13 comprend des éléments communs avec le condensateur C de la figure 4. Seules les différences entre les deux structures seront détaillées ci-après.

Dans le condensateur de la figure 13, outre les plaques conductrices 301a, 301b, 303a, 303b, 305a, 305b, l'ensemble fixe comprend deux plaques conductrices supplémentaires 501a et 501b sensiblement horizontales et en vis-à-vis l'une de l'autre, connectées électriquement au noeud de sortie out de la cellule. Dans cet exemple, l'électrode s du condensateur est formée par les plaques conductrices 301a, 301b, 501a et 501b.

De plus, outre les plaques conductrices 302, 304 et 306, l'ensemble mobile du condensateur C de la figure 13 comprend une plaque conductrice supplémentaire 502 sensiblement horizontale, connectée électriquement au noeud d'alimentation sup de la cellule. Dans cet exemple, l'électrode d du condensateur est formée par les plaques 302 et 502.

L'ensemble fixe et l'ensemble mobile sont agencés de façon que la plaque conductrice mobile supplémentaire 502 soit disposée entre les plaques conductrices 501a et 501b, au moins partiellement en vis-à-vis des plaques conductrices 501a et 501b, sensiblement à équidistance des plaques conductrices 501a et 501b.

Dans le condensateur C de la figure 13, l'ensemble fixe et l'ensemble mobile sont agencés de façon que lorsque la surface de la plaque conductrice mobile 304 en vis-à-vis des plaques conductrices fixes 303a et 303b augmente :

la distance de non recouvrement $d_{ar}$ entre la plaque conductrice 302 et les plaques conductrices 301a et 301b diminue, ou la surface de la plaque conductrice 302 en vis-à-vis des plaques conductrices 301a et 301b augmente ;
la surface de la plaque conductrice 502 en vis-à-vis des plaques conductrices 501a et 501b augmente ; et
la surface de la plaque conductrice 306 en vis-à-vis des plaques conductrices 305a et 305b diminue,

et inversement.

Le condensateur C de la figure 13 est adapté à mettre en oeuvre une fonction OUI (S=A) pour le signal A appliqué sur le noeud d'entrée in1, et une fonction NON (S=$\overline{B}$) pour le signal B appliqué sur le noeud d'entrée in2, étant entendu que les deux fonctions ne peuvent pas être mises en oeuvre simultanément. Autrement dit, lorsque la fonction OUI est utilisée, le signal B doit être mis à un état bas ou le noeud in2 doit être laissé flottant, et, lorsque la fonction NON est utilisée, le signal A doit être mis à un état bas, ou le noeud in1 doit être laissé flottant.

Un avantage du mode de réalisation de la figure 13 est qu'il permet, au moyen d'une même cellule logique à deux entrées et une sortie, de mettre en oeuvre deux fonctions logiques distinctes, sélectionnables par le choix de l'entrée sur laquelle est appliqué le signal logique d'entrée.

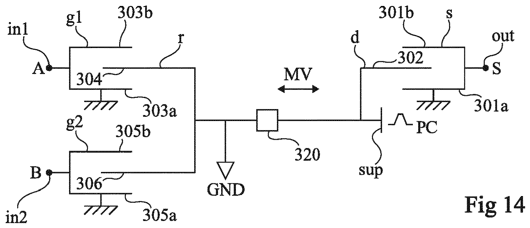

La figure 14 est une vue en coupe simplifiée d'un autre exemple de réalisation du condensateur à capacité variable C de la figure 2, adapté pour la mise en oeuvre d'une fonction logique NON OU.

Le condensateur C de la figure 14 diffère du condensateur C de la figure 3 essentiellement en ce que, dans l'exemple de la figure 14, l'ensemble fixe et l'ensemble mobile sont agencés de façon que lorsque la surface de l'une des plaques conductrices mobiles 304 et 306 en vis-à-vis des plaques conductrices fixes correspondantes 303a et 303b, respectivement 305a et 305b augmente, la surface de la plaque conductrice mobile 302 en vis-à-vis des plaques conductrices fixes correspondantes 301a et 301b diminue, et inversement.

Des modes de réalisation particuliers ont été décrits.

## Revendications

1. Cellule logique capacitive comportant un condensateur (C) à capacité variable comportant des première (s), deuxième (d), troisième (g1), quatrième (g2) et cinquième (r ; r1) électrodes isolées électriquement les unes des autres, le condensateur (C) comportant un ensemble fixe comportant la première électrode (s), et un ensemble mobile comportant la deuxième électrode (d), dans laquelle :

les première (s) et deuxième (d) électrodes définissent une première capacité variable du condensateur (C) en fonction de la position de l'ensemble mobile par rapport à l'ensemble fixe ;
la troisième électrode (g1) est connectée à un noeud (in1) d'application d'un premier signal logique d'entrée (A ; A1) de la cellule ;
la quatrième électrode (g2) est connectée à un noeud (in2) d'application d'un deuxième signal logique d'entrée (B ; A2) de la cellule ;
la cinquième électrode (r ; r1) est connectée à un noeud (GND ; GND1) d'application d'un premier potentiel de référence de la cellule ; et

la position de la deuxième électrode (d) par rapport à la première électrode (s) est fonction d'une combinaison des premier (A ; A1) et deuxième (B ; A2) signaux logiques d'entrée,

dans laquelle :

l'ensemble mobile est mobile en translation par rapport à l'ensemble fixe de façon à faire varier la surface de la deuxième électrode (d) en vis-à-vis de la première électrode (s) sans faire varier la distance entre les première (s) et deuxième (d) électrodes ; ou
l'ensemble mobile est mobile en translation par rapport à l'ensemble fixe de façon à faire varier la distance entre les première (s) et deuxième (d) électrodes sans faire varier la surface de la deuxième électrode (d) en vis-à-vis de la première électrode (s),

et dans laquelle :

la deuxième électrode (d) est connectée à un noeud (sup) d'application d'une tension d'alimentation (PC) de la cellule ;
la première électrode (s) est connectée à un noeud (out) de fourniture d'un premier signal logique de sortie (S) de la cellule ; et
une capacité de sortie ($C_L$) est connectée entre la première électrode (s) et le noeud (GND ; GND1) d'application du premier potentiel de référence de la cellule.

2. Cellule selon la revendication 1, dans laquelle les premier (A) et deuxième (B) signaux logiques d'entrée sont référencés par rapport audit noeud (GND) d'application d'un premier potentiel de référence.

3. Cellule selon la revendication 1, comportant en outre une sixième (r2) électrode isolée électriquement des première (s), deuxième (d), troisième (g1), quatrième (g2) et cinquième (r1) électrodes, la sixième électrode (r2) étant connectée à un noeud (GND2) d'application d'un deuxième potentiel de référence, dans laquelle le premier signal logique d'entrée (A) est référencé par rapport audit noeud (GND1) d'application d'un premier potentiel de référence et le deuxième signal logique d'entrée (B) est référencé par rapport audit noeud (GND2) d'application d'un deuxième potentiel de référence.

4. Cellule selon l'une quelconque des revendications 1 à 3, comportant un premier dispositif d'actionnement électrostatique apte à provoquer un déplacement de l'ensemble mobile par rapport à l'ensemble fixe en fonction de l'état du premier signal logique d'entrée (A), et un deuxième dispositif d'actionnement électrostatique apte à provoquer un déplacement de l'ensemble mobile par rapport à l'ensemble fixe en fonction de l'état du deuxième signal logique d'entrée (B).

5. Cellule selon l'une quelconque des revendications 1 à 3, comportant un dispositif d'actionnement électrostatique apte à provoquer un déplacement de l'ensemble mobile par rapport à l'ensemble fixe en fonction de l'état du premier signal logique d'entrée (A), et un dispositif d'actionnement électrodynamique apte à provoquer un déplacement de l'ensemble mobile par rapport à l'ensemble fixe en fonction de l'état du deuxième signal logique d'entrée (B).

6. Cellule selon l'une quelconque des revendications 1 à 5, dans laquelle la première électrode (s) comprend des première (301a, 301b ; 401a) et deuxième (301a', 301b' ; 401b) portions conductrices interconnectées, disposées de part et d'autre de la deuxième électrode (d) de façon à limiter l'influence de la tension entre les première (s) et deuxième (d) électrodes sur la position de l'ensemble mobile par rapport à l'ensemble fixe.

7. Cellule selon l'une quelconque des revendications 1 à 6, comportant une septième électrode (g3) connectée à un noeud (in3) d'application d'un troisième signal logique d'entrée (A3) de la cellule, dans laquelle la position de la deuxième électrode (d) par rapport à la première électrode (s) est fonction d'une combinaison des premier (A1), deuxième (A2) et troisième (A3) signaux logiques d'entrée.

8. Cellule selon l'une quelconque des revendications 1 à 7, dans laquelle l'ensemble fixe comprend une huitième électrode (s') isolée électriquement de la première électrode (s), les huitième (s') et deuxième (d) électrodes définissant une deuxième capacité variable en fonction de la position de l'ensemble mobile par rapport à l'ensemble fixe.

9. Cellule selon la revendication 8, dans laquelle la huitième électrode (s') est connectée à un noeud (out') de fourniture d'un deuxième signal logique de sortie (S') de la cellule.

**Patentansprüche**

1. Kapazitive Logikzelle, die einen Kondensator (C) mit variabler Kapazität aufweist, der eine erste (s), zweite (d), dritte (g1), vierte (g2) und fünfte (r ; r1) Elektrode aufweist, die elektrisch voneinander isoliert sind, wobei der Kondensator (C) eine feste Baugruppe, die die erste Elektrode (s) aufweist, und eine bewegliche Baugruppe, die die zweite Elektrode (d) aufweist, aufweist, wobei:

die erste (s) und die zweite (d) Elektrode eine erste variable Kapazität des Kondensators (C) in Abhängigkeit von der Position der beweglichen Baugruppe relativ zu der festen Baugruppe definieren;

die dritte Elektrode (g1) mit einem Knoten (in1) zum Anlegen eines ersten logischen Eingangssignals (A; A1) der Zelle verbunden ist;

die vierte Elektrode (g2) mit einem Knoten (in2) zum Anlegen eines zweiten logischen Eingangssignals (B; A2) der Zelle verbunden ist;

die fünfte Elektrode (r; r1) mit einem Knoten (GND; GND1) zum Anlegen eines ersten Bezugspotentials der Zelle verbunden ist; und

die Position der zweiten Elektrode (d) relativ zur ersten Elektrode (s) eine Funktion einer Kombination des ersten (A; A1) und zweiten (B; A2) logischen Eingangssignals ist,

wobei:

die bewegliche Baugruppe in Bezug auf die feste Baugruppe translatorisch beweglich ist, um den Oberflächenbereich der zweiten Elektrode (d) gegenüber der ersten Elektrode (s) zu verändern, ohne den Abstand zwischen der ersten (s) und der zweiten (d) Elektrode zu verändern; oder

die bewegliche Baugruppe in Bezug auf die feste Baugruppe translatorisch beweglich ist, um den Abstand zwischen der ersten (s) und der zweiten (d) Elektrode zu variieren, ohne den Oberflächenbereich der zweiten Elektrode (d) gegenüber der ersten Elektrode (s) zu verändern,

und wobei:

die zweite Elektrode (d) mit einem Knoten (sup) zum Anlegen einer Stromversorgungsspannung (PC) der Zelle verbunden ist;

die erste Elektrode (s) mit einem Knoten (out) zum Liefern eines ersten logischen Ausgangssignals (S) der Zelle verbunden ist; und

eine Ausgangskapazität ($C_l$) zwischen der ersten Elektrode (s) und dem Knoten (GND; GND1) zum Anlegen des ersten Bezugspotentials der Zelle angeschlossen ist.

2. Zelle nach Anspruch 1, wobei das erste (A) und das zweite (B) logische Eingangssignal auf den Knoten (GND) zum Anlegen eines ersten Bezugspotentials bezogen sind.

3. Zelle nach Anspruch 1, die weiterhin eine sechste (r2) Elektrode aufweist, die von der ersten (s), zweiten (d), dritten (g1), vierten (g2) und fünften (r1) Elektrode elektrisch isoliert ist, wobei die sechste Elektrode (r2) mit einem Knoten (GND2) zum Anlegen eines zweiten Bezugspotentials verbunden ist, wobei das erste logische Eingangssignal (A) auf den Knoten (GND1) zum Anlegen eines ersten Bezugspotentials bezogen ist und das zweite logische Eingangssignal (B) auf den Knoten (GND2) zum Anlegen eines zweiten Bezugspotentials bezogen ist.

4. Zelle nach einem der Ansprüche 1 bis 3, mit einer ersten elektrostatischen Betätigungsvorrichtung, die in der Lage ist, eine Verschiebung der beweglichen Baugruppe in Bezug auf die feste Baugruppe in Abhängigkeit vom Zustand des ersten logischen Eingangssignals (A) zu bewirken, und mit einer zweiten elektrostatischen Betätigungsvorrichtung, die in der Lage ist, eine Verschiebung der beweglichen Baugruppe in Bezug auf die feste Baugruppe in Abhängigkeit vom Zustand des zweiten logischen Eingangssignals (B) zu bewirken.

5. Zelle nach einem der Ansprüche 1 bis 3, mit einer elektrostatischen Betätigungsvorrichtung, die in der Lage ist, eine Verschiebung der beweglichen Baugruppe in Bezug auf die feste Baugruppe in Abhängigkeit vom Zustand des ersten logischen Eingangssignals (A) zu bewirken, und mit einer elektrodynamischen Betätigungsvorrichtung, die in der Lage ist, eine Verschiebung der beweglichen Baugruppe in Bezug auf die feste Baugruppe in Abhängigkeit vom Zustand des zweiten logischen Eingangssignals (B) zu bewirken.

6. Zelle nach einem der Ansprüche 1 bis 5, wobei die erste Elektrode (s) erste (301a, 301b; 401a) und zweite (301a', 301b'; 401b) miteinander verbundene leitende Abschnitte aufweist, die auf beiden Seiten der zweiten Elektrode (d) angeordnet sind, um den Einfluss der Spannung zwischen der ersten (s) und der zweiten (d) Elektrode auf die Position der beweglichen Baugruppe relativ zur festen Baugruppe zu begrenzen.

7. Zelle nach einem der Ansprüche 1 bis 6, die eine siebte Elektrode (g3) aufweist, die mit einem Knoten (in3) zum Anlegen eines dritten logischen Eingangssignals (A3) der Zelle verbunden ist, wobei die Position der zweiten Elektrode (d) relativ zur ersten Elektrode (s) eine Funktion einer Kombination des ersten (A1), zweiten (A2) und dritten (A3) logischen Eingangssignals ist.

8. Zelle nach einem der Ansprüche 1 bis 7, wobei die feste Baugruppe eine achte Elektrode (s') aufweist, die von der ersten Elektrode (s) elektrisch isoliert ist, wobei die achte (s') und zweite (d) Elektrode einen zweiten Kondensator definieren, der entsprechend der Position der beweglichen Baugruppe relativ zur festen Baugruppe variabel ist.

9. Zelle nach Anspruch 8, wobei die achte Elektrode (s') mit einem Knoten (out') zum Liefern eines zweiten logischen Ausgangssignals (S') der Zelle verbunden ist.

## Claims

1. A capacitive logic cell comprising a variable capacitance capacitor (C) comprising first (s), second (d), third (g1), fourth (g2) and fifth (r ; r1) electrodes electrically insulated one from each other, the capacitor (C) comprising a fixed assembly comprising the first electrode (s), and a mobile assembly comprising the second electrode (d), wherein:

the first (s) and second (d) electrodes define a first variable capacitance of the capacitor (C) according to the position of the mobile assembly relative to the fixed assembly;
the third electrode (g1) is connected to a node (in1) of application of a first logic input signal (A; A1) of the cell;
the fourth electrode (g2) is connected to a node (in2) of application of a second logic input signal (B; A2) of the cell;
the fifth electrode (r; r1) is connected to a node (GND; GND1) of application of a first reference potential of the cell; and
the position of the second electrode (d) relative to the first electrode (s) is a function of a combination of the first (A; A1) and second (B; A2) logic input signals,

wherein:

the mobile assembly is mobile in translation with respect to the fixed assembly to vary the surface area of the second electrode (d) opposite the first electrode (s) without varying the distance between the first (s) and second (d) electrodes; or
the mobile assembly is mobile in translation with respect to the fixed assembly to vary the distance between the first (s) and second (d) electrodes without varying the surface area of the second electrode (d) opposite the first electrode (s),

and wherein:

the second electrode (d) is connected to a node (sup) of application of a power supply voltage (PC) of the cell;
the first electrode (s) is connected to a node (out) supplying a first logic output signal (S) of the cell; and
an output capacitance (C$_l$) is connected between the first electrode (s) dans the node (GND; GND1) of application of the first reference potential of the cell.

2. The cell of claim 1, wherein the first (A) and second (B) logic input signals are referenced to said node (GND) of application of a first reference potential.

3. The cell of claim 1, further comprising a sixth (r2) electrode electrically insulated from the first (s), second (d), third (g1), fourth (g2), and fifth (r1) electrodes, the sixth electrode (r2) being connected to a node (GND2) of application of a second reference potential, wherein the first logic input signal (A) is referenced to said node (GND1) of application of a first reference potential and the second logic input signal (B) is referenced to said node (GND2) of application of a second reference potential.

4. The cell of any of claims 1 to 3, comprising a first electrostatic actuation device capable of causing a displacement of the mobile assembly with respect to the fixed assembly according to the state of the first logic input signal (A), and a second electrostatic actuation device capable of causing a displacement of the mobile assembly with respect to the fixed assembly according to the state of the second logic input signal (B) .

5. The cell of any of claims 1 to 3, comprising an electrostatic actuation device capable of causing a displacement of the mobile assembly with respect to the fixed assembly according to the state of the first logic input signal (A), and an electrodynamic actuation device capable of causing a displacement of the mobile assembly with respect to the fixed assembly according to the state of the second logic input signal (B).

6. The cell of any of claims 1 to 5, wherein the first electrode (s) comprises first (301a, 301b; 401a) and second (301a', 301b'; 401b) interconnected conductive portions arranged on either side of the second electrode (d) to limit the influence of the voltage between the first (s) and second (d) electrodes on the position of the mobile assembly relative to the fixed assembly.

7. The cell of any of claims 1 to 6, comprising a seventh electrode (g3) connected to a node (in3) of application of a third logic input signal (A3) of the cell, wherein the position of the second electrode (d) relative to the first electrode (s) is a function of a combination of the first (A1), second (A2), and third (A3) logic input signals.

8. The cell of any of claims 1 to 7, wherein the fixed assembly comprises an eighth electrode (s') electrically insulated from the first electrode (s), the eighth (s') and second (d) electrodes defining a second capacitor variable according to the position of the mobile assembly relative to the fixed assembly.

9. The cell of claim 8, wherein the eighth electrode (s') is connected to a node (out') supplying a second logic output signal (S') of the cell.

Fig 1

Fig 2

Fig 3

Fig 4

Fig 5

Fig 6

Fig 7

Fig 8

Fig 9

Fig 10

C

in1
A
404    r
g1
403
MV
406
GND
320
in2
B
g2
405

out
S=A+B
s    401b
402    d
401a    d2
d1
sup
PC

**Fig 11**

C

in1(g1)
504
503
523
521
g2    305b
B
in2    306
305a

out
S=A+B
s    301b
302    d
301a
320
MV
GND

PC
sup

**Fig 12**

C

in1    g1    303b
A    r
304
303a    MV
320
GND
305b
306    g2
in2    B
305a

out    s    301b
S
302    d
301a

d_ar

out    s    501b
S
502
501a

**Fig 13**

21

Fig 14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 16204534 A
- US 15381477 B
- US 6242989 B1